**Europäisches Patentamt**

**European Patent Office**

**Office européen des brevets**

(19)

(11) Veröffentlichungsnummer : **0 014 391**
**B1**

# (12) EUROPÄISCHE PATENTSCHRIFT

(45) Veröffentlichungstag der Patentschrift :
22.09.82

(21) Anmeldenummer : 80100372.4

(22) Anmeldetag : 24.01.80

(51) Int. Cl.³ : **H 05 K  7/14**

---

(54) Baugruppen-Baugruppenträger-System für elektronische-Schaltungen.

---

(30) Priorität : 07.02.79 DE 2904604

(43) Veröffentlichungstag der Anmeldung :
20.08.80 (Patentblatt 80/17)

(45) Bekanntmachung des Hinweises auf die Patenterteilung : 22.09.82 Patentblatt 82/38

(84) Benannte Vertragsstaaten :
AT BE CH DE FR GB IT LU NL SE

(56) Entgegenhaltungen :
DD A 100 379
DE B 2 143 338
DE U 7 710 933
DE U 7 818 588
US A 2 894 077
US E 25 317

(73) Patentinhaber : SIEMENS AKTIENGESELLSCHAFT
Berlin und München
Postfach 22 02 61
D-8000 München 22 (DE)

(72) Erfinder : Keller, Roman
Grossenbuch Nr. 126.
D-8524 Neunkirchen a. Br. (DE)

Baugruppen-Baugruppenträger-System für elektronische Schaltungen

Die Erfindung betrifft ein Baugruppen-Baugruppenträger-System für elektronische Schaltungen, wobei jede Baugruppe in den Baugruppenträger einschiebbar ist und eine rechteckige Leiterplatte umfaßt, bei der wenigstens eine Seitenfläche mit elektronischen Bauelementen bestückt ist und an einer vorgegebenen Stelle auf beiden Seitenflächen jeder Leiterplatte je ein Stützbolzen befestigt ist, wobei die freie Stirnfläche jedes Stützbolzens als ebene Auflagefläche ausgebildet ist und auf der Auflagefläche des benachbarten Stützbolzens aufliegt und wobei jedes Seitenteil des Baugruppenträgers einen nach innen abstehenden, mit einer ebenen Auflagefläche versehenen Stützbolzen aufweist, der mit den Stützbolzen der Leiterplatten der Baugruppen fluchtet und mit seiner Auflagefläche auf der Auflagefläche des benachbarten Stützbolzens aufliegt.

Ein solches Baugruppen-Baugruppenträger-System ist aus der US-A-Re. 25 317 bekannt. Dort ist der Aufbau eines Verstärkers mit mehreren, identisch bestückten und aufgebauten Baugruppen beschrieben, wobei jede Baugruppe eine gesonderte Verstärkerstufe bildet. Jede Baugruppe ist in einen Stecker des kastenförmigen Baugruppenträgers eingesteckt, wobei die Stecker auf Führungsschienen in Längs- bzw. Axialrichtung des Baugruppenträgers verschiebbar in diesem befestigt sind. Über die Stecker sind die Baugruppen lediglich mit der elektrischen Versorgungsleitung verbunden. Die zu verarbeitenden Hf-Signale werden von jeder Baugruppe auf die nachfolgende durch induktive Kopplung übertragen. Hierzu besitzt jede Baugruppe eine — vorzugsweise als gedruckte Schaltung ausgeführte — flache Eingangs- und Ausgangsspule. Sowohl die Eingangs- als auch die Ausgangsspule sind erhöht auf der Leiterplatte jeder Baugruppe so angeordnet, daß im Baugruppenträger die Eingangsspule jeder Baugruppe mit der Ausgangsspule der vorangehenden Baugruppe fluchtet und an dieser elektrisch isoliert anliegt. Durch mit Schrauben betätigbare Andruckplatten in den Seitenwänden des Baugruppenträgers werden alle Baugruppen nach ihrer Montage axial zusammengepreßt, was wegen der seitlich verschiebbaren Stecker ohne Beschädigung der Baugruppen möglich ist. Durch dieses Zusammenpressen der Baugruppen wird eine gute induktive Kopplung zwischen den Baugruppen erhalten, wobei zur Abschirmung die Leiterplatte jeder Baugruppe einseitig mit einem Metallüberzug versehen ist. Um beim axialen Zusammenpressen ein Verkanten der Baugruppen im Baugruppenträger zu vermeiden, können die Baugruppen so ausgebildet sein, daß sie mit vollem Flächenkontakt aneinanderliegen. Bei einer anderen Ausführungsform sind neben den Eingangs- und Ausgangsspulen auf jeder Leiterplattenseite jeder Baugruppe gesonderte, jeweils mit der Eingangsoder Ausgangsspule der anderen Leiterplattenseite fluchtende Abstandshalter vorgesehen, deren Höhe der Höhe der Blöcke für die Eingangs- bzw. Ausgangsspule entspricht und die in Einsteckrichtung abgeschrägt sind. Mit solchen im Baugruppenträger mit axialer Kraft zusammengepreßten Baugruppenstapeln wird nicht nur eine gute induktive Kopplung der Baugruppen erreicht, sondern die Baugruppen sind im Stapel auch gegen Herausrutschen und gegen Schwingungseinwirkungen gesichert. Diese Maßnahmen zur Sicherung einer guten induktiven Kopplung bei gleichzeitiger hoher mechanischer Stabilität und Rüttelsicherheit sind an den Aufbau des Baugruppenträgers mit seinen verschiebbaren Steckern und an den Einsatz weitgehend identisch aufgebauter Baugruppen gebunden. Bei den mittlerweilen genormten Baugruppenträgern mit fest eingebauten Steckern und bei völlig unterschiedlich aufgebauten Baugruppen ist das axiale Zusammenpressen der Baugruppen im Baugruppenträger mittels einer gesondert aufgebrachten axialen Kraft nicht durchführbar.

Standardisierte, der modernen Aufbautechnik entsprechende Baugruppen und Baugruppenträger sind aus der Siemens-Zeitschrift 46 (1972), Seiten 277 bis 279 und der DIN 41 494 bekannt. Diese Baugruppenträger sind aus rechteckigen Seitenteilen aufgebaut, die mit vier Verbindungsstegen an den Ecken verschraubt sind. Die Verbindungsstege sind mit einem Bohrungsraster versehen, dessen Teilungsmaß nach DIN 41 494 genormt ist. Der Abstand zwischen zwei Bohrungen beträgt 5,08 mm. In diese Befestigungslochreihen werden die Federleisten von Steckverbindern und Kunststoff-Führungsleisten eingerastet, in die die Leiterplatten der Baugruppen eingeschoben werden. Bei der Bestückung der Baugruppenträger kann die Platzaufteilung grundsätzlich in Schritten des oben angegebenen Teilungsmaßes vorgenommen werden. Die kleinste Breite eines Standard-Einbauplatzes ist jedoch mit drei Teilungsschritten definiert. Jeder Einbauplatz ist durch Teilungslinien bzw. Teilungsebenen begrenzt, wobei die Frontplatte der Baugruppe und die elektronischen Bauelemente mit denen die Leiterplatte bestückt ist, nicht über diese beidseitigen Teilungsebenen hinausragen dürfen, um ein ungehindertes Einschieben und Ziehen der Baugruppe zu gewährleisten.

Werden solche bestückte Baugruppenträger einer Rütteloder Schockbelastung ausgesetzt, wie sie beispielsweise in Fahrzeugen auftreten kann, so kann dies zu Schwingungen gegebenenfalls sogar zu Resonanzschwingungen der Leiterplatten führen. Solche Schwingungen gefährden die Betriebssicherheit der mit den Leiterplatten aufgebauten elektronischen Einrichtung.

Es besteht die Aufgabe, ein Baugruppen-Baugruppenträger-System der eingangs genannten Art unter Berücksichtigung der genormten, festliegenden Platzaufteilung so aufzubauen, daß Schwingungen weiterhin weitgehend unterdrückt und damit Rüttelsicherheit der Baugruppen gegeben ist.

Erfindungsgemäße wird diese Aufgabe dadurch gelöst, daß der Baugruppenträger ein durch Lochleisten definiertes Teilungsmaß aufweist, daß die Baugruppen in Führungsleisten eingeschoben sind, die in Löcher der Lochleisten befestigt sind, daß die Gesaltlänge beider Stützbolzen einer Leiterplatte zusammen mit der Dicke der Leiterplatte einem ganzzahligen Vielfachen des Teilungsmaßes entspricht und die Länge jedes Stützbolzens so gewählt ist, daß seine Auflagefläche in einer durch das Teilungsmaß des Baugruppenträgers gegebenen Teilungsebene liegt, wobei die Auflageflächen der von den Seitenteilen abstehenden Stützbolzen in der ersten, dem zugehörigen Seitenteil benachbarten Teilungsebene liegen.

Bei dem erfindungsgemäßen Baugruppen-Baugruppenträger-System liegen bei eingeschobenen Baugruppen die Auflageflächen jedes Stützbolzens an der Auflagefläche eines Stützbolzens einer benachbarten Baugruppe oder eines Seitenteils an, wobei die Abmessungen der Stützbolzen sicherstellen, daß alle Auflageflächen zwischen Stützbolzen in einer Teilungsebene des Baugruppenträgers liegen. Die Baugruppen sind damit praktish ohne weitere Maßnahme zwischen die Seitenteile des Baugruppenträgers eingeklemmt. Damit stützen sich die Baugruppen nicht nur gegenseitig schwingungsverhindernd ab, sondern bei Schwingungen wirkt nicht nur die Dämpfung durch die benachbarten Baugruppen, sondern es wirkt auch noch die Dämpfung durch die Seitenteile, die im allgemeinen wesentlich stabiler als die Leiterplatten der Baugruppen sind. Rüttelsicherheit und Schwingungsfreiheit ist damit auch bei größeren Rüttel- und Schockbeanspruchungen gewährleistet.

Vorteilhaft ist es, die Stützbolzen etwa im Schnittpunkt der Diagonalen der Leiterplatte zu befestigen. Damit liegen die Stützbolzen etwa im Schwingungsbauch der Grundschwingung der Leiterplatte. Die Erfahrung zeigte, daß praktisch jeder Baugruppe in einem Baugruppenträger eine andere Resonanzfrequenz besitzt. Auch Baugruppen gleicher Ausführung zeigen Resonanztoleranzen von ca. ± 2 Hz. Bei einer Rüttelbeanspruchung kann man daher davon ausgehen, daß immer nur eine Baugruppe des Baugruppenträgers unter Resonanzbedingungen steht. Mit der gegenseitigen Abstützung, die mit der erfindungsgemäßen Ausführung erreicht wird, wirken daher auch bei Resonanz die benachbarten Baugruppen dämpfend auf die Baugruppe ein, die unter Resonanzbedingungen steht. Mit der erfindungsgemäßen Ausgestaltung des Baugruppen-Baugruppenträger-Systems wird außerdem durch die gegenseitige Abstützung der Stützbolzen ein definierten Abstand zwischen den beiden Platten und den elektronischen Bauelementen benachbarter Baugruppen festgelegt.

Damit ist ohne weitere Maßnahmen die Einhaltung von den Sicherheitsvorschriften entsprechenden Isolationsabständen gewährleistet.

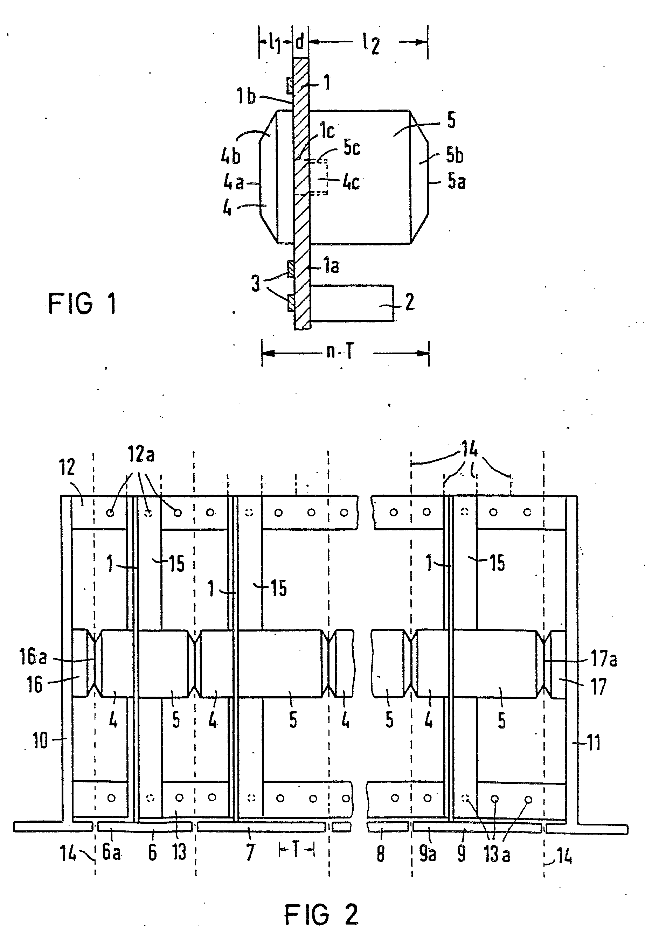

Im folgenden wird ein erfindungsgemäßes Baugruppen-Baugruppenträger-System beispielhaft anhand der Figuren 1 und 2 näher erläutert. Dabei sind in den Figuren gleiche Bauteile mit den gleichen Bezugszeichen versehen.

Figur 1 zeigt einen Teilschnitt durch die Leiterplatte 1 einer Baugruppe. Bei der Leiterplatte 1 sind auf der Bauteilseite 1a elektronische bzw. elektromechanische Bauelemente 2 und auf der Lötseite 1b Leiterbahnen 3 schematisch gezeigt. Auf jeder der Seitenflächen 1a und 1b ist ein Stützbolzen 4 und 5 befestigt. Jeder Stützbolzen besitzt an seinem freien Ende eine ebene Auflagefläche 4a und 5a. Außerdem sind an den freien Enden schräge Anlaufflächen 4b bzw. 5b vorgesehen, die in die Auflageflächen 4a bzw. 5a übergehen. Mit diesen schrägen Anlaufflächen 4b und 5b wird sowohl beim Einschieben als auch beim Ziehen der Baugruppen der Eingriff der Stützbolzen und das Lösen der Stützbolzen erleichtert. Beim Ausführungsbeispiel sind die Stützbolzen 4 und 5 als Zylinder ausgeführt und die Anlaufflächen 4b und 5b sind konische Abschrägungen. Selbstverständlich können die Stützbolzen 4 und 5 auch quaderförmig ausgebildet sein und die Anlaufflächen 4b und 5b brauchen nur in Einsteckrichtung der Baugruppen vorgesehen sein.

Die Gesamtlänge der beiden Stützbolzen 4 und 5 zusammen mit der Dicke d der Leiterplatte 1 beträgt ein ganzzahliges Vielfaches $n \times T$ des Teilungsmaßes $T$ des Baugruppenträgers, wobei die Längen $l_1$ und $l_2$ der Stützbolzen 4 und 5 so gewählt sind, daß die Auflageflächen 4a und 5a in einer Teilungsebene des Baugruppenträgers liegt, die durch die Normung festgelegt ist. Damit ist sichergestellt, daß mit Stützbolzen ausgerüstete Baugruppen frei in jeden genormten Baugruppenträger eingeschoben und aus ihm herausgezogen werden können, ohne daß benachbarte Baugruppen entfernt werden müssen.

Figur 1 zeigt weiterhin eine günstige Befestigung der Stützbolzen 4 und 5. Einer der Stützbolzen, im Ausführungsbeispiel der Stützbolzen 4, ist mit einer Schraube 4c versehen, die durch eine Bohrung 1c in der Leiterplatte 1 hindurch in einer Gewindebohrung 5c des Stützbolzens 5 verschraubt ist. Damit ist eine einfache und sichere Montage der beiden Stützbolzen 4 und 5 an der Leiterplatte 1 gewährleistet.

Die Stützbolzen 4 und 5 können aus Kunststoff hergestellt sein. Günstig ist es außerdem noch, einen Querschnitt für die Stützbolzen zu wählen, der in etwa dem Querschnitt üblicher elektronischer Bauteile, beispielsweise dem Querschnitt eines Transistors oder eines integrierten Schaltkreises entspricht.

Anzumerken ist noch, daß durch die gegenseitige Abstützung der Stützbolzen 4 und 5 benachbarter Baugruppen der Abstand zwischen den Leiterplatten benachbarter Baugruppen auf die

Summe $l_1 + l_2$ der Längen $l_1$ und $l_2$ der Stütz-bolzen 4 und 5 festgelegt ist. Der zur Einhaltung von Sicherheitsvorschriften erforderliche Isolationsabstand zwischen Bauelementen 2 und/oder Leiterbahnen 3a benachbarter Baugruppen ist damit mit sehr geringen Toleranzgrenzen vorgegeben und diese vorgegebenen Isolierstrecken bleiben auch bei Rüttelbeanspruchung ohne weitere Maßnahmen unverändert.

Figur 2 zeigt schematisch eine Draufsicht auf einen Baugruppenträger, der mit Baugruppen 6 bis 9 bestückt ist, die entsprechend Figur 1 ausgeführt sind. Der Baugruppenträger besteht aus zwei Seitenteilen 10 und 11, die über Verbindungsstege 12 und 13 miteinander verbunden sind. Jeder Verbindungssteg 12 bzw. 13 besitzt eine Reihe von Löchern 12a bzw. 13a mit dem genormten Teilungsmaß T. Durch die Mittellinie zwischen jeweils zwei Löchern der Lochreihen 12a und 13a ist jeweils eine Trennungslinie bzw. Trennungsebene 14 festgelegt, die ebenfalls der Norm entspricht.

In den Löchern 12a und 13a sind Führungsleisten 15 für die Baugruppen 6 bis 9 befestigt. In diese Führungsleisten werden die Baugruppen eingeschoben. Für jede Baugruppe ist ein Einbauplatz vorgesehen, dessen Breite durch Tei-lungsebenen 14 begrenzt ist. Als Standard-Einbauplatz ist durch die Normung ein Einbauplatz definiert, dessen Breite $3 \times T$ beträgt. Die Breite des benötigten Einbauplatzes wird von der Höhe der elektronischen Bauelemente bestimmt, mit denen die Leiterplatte 1 einer bestimmten Baugruppe bestück ist. Die Breite der Frontplatte 6a bis 9a jeder Baugruppe entspricht dann der Breite des Einbauplatzes, um eine frontseitige Abdeckung des bestückten Baugruppenträgers zu gewährleisten. Im Ausführungsbeispiel nach Figur 2 sind Einbauplätze mit unterschiedlicher Breite gezeigt.

Im die Übersichtlichkeit zu wahren, sind bei den Baugruppen 6 bis 9 der Figur 2 die elektronischen Bauelemente weggelassen, mit denen die Leiterplatten 1 bestückt sind und auch die Leiterbahnen sind nicht gezeigt, mit denen die elek-tronischen Bauelemente elektrisch leitend ver-bunden sind. Außerdem sind die Federleisten und Steckverbinder nicht gezeigt, die an der Rückseite des Baugruppenträgers und der Baugruppen vorzusehen sind.

Der Figur 2 ist zu entnehmen, daß bei den eingeschobenen Baugruppen 6 bis 9 die Auflageflächen 4a und 5a der Stützbolzen 4 und 5 sich gegenseitig abstützen. Wie oben bereits näher erläutert, werden damit Schwingungen weitgehend unterdrückt bzw. gedämpft, die bei einer Rütteloder Schockbeanspruchung auftreten können. Zusätzlich sind bei dem Ausführungsbeispiel nach Figur 2 die Seitenteile 10 und 11 des Baugruppenträgers mit Stützbolzen 16 und 17 versehen, deren Auflageflächen 16a und 17a in der jeweils benachbarten ersten Teilungsebene 14 liegen und gegen die sich der Stützbolzen der benachbarten Baugruppe 6 bzw. 9 abstützt. Damit sind alle Leiterplatten über den durchgehenden Steg von Stützbolzen 4 und 5 und die Stützbolzen 16 und 17 zwischen die Seitenteile 10 und 11 des Baugruppenträgers eingeklemmt, womit Rüttelsicherheit auch bei größeren Beanspruchungen gewährleistet ist.

## Ansprüche

1. Baugruppen-Baugruppenträger-System für elektronische Schaltungen, wobei jede Baugruppe in den Baugruppenträger einschiebbar ist und eine rechteckige Leiterplatte umfaßt, bei der wenigstens eine Seitenfläche mit elektronischen Bauelementen bestückt ist und an einer vorgegebenen Stelle auf beiden Seitenflächen jeder Leiterplatte je ein Stützbolzen befestigt ist, wobei die freie Stirnfläche jedes Stützbolzens als ebene Auflagefläche ausgebildet ist und auf der Auflagefläche des benachbarten Stützbolzens aufliegt und wobei jedes Seitenteil des Baugruppenträgers einen nach innen abstehenden, mit einer ebenen Auflagefläche versehenen Stützbolzen aufweist, der mit den Stützbolzen der Leiterplatten der Baugruppen fluchtet und mit seiner Auflagefläche auf der Auflagefläche des benachbarten Stützbolzens aufliegt, dadurch gekennzeichnet, daß der Baugruppenträger ein durch Lochleisten (12 bzw. 13) definiertes Teilungsmaß (T) aufweist, daß die Baugruppen in Führungsleisten (15) eingeschoben sind, die in Löcher (12a bzw. 13a) der Lochleisten (12 bzw. 13) befestigt sind, daß die Gesamtlänge beider Stützbolzeb (4 bzw. 5) einer Leiterplatte (1) zusammen mit der Dicke (d) der Leiterplatte (1) einem ganzzahligen Vielfachen $(n \times T)$ des Teilungsmaßes (T) entspricht und die Länge ($l_1$ bzw. $l_2$) jedes Stützbolzens so gewählt ist, daß seine Auflagefläche (4a bzw. 5a) in einer durch das Teilungsmaß (T) des Baugruppenträgers gegebenen Teilungsebene (14) liegt, wobei die Auflageflächen (16a bzw. 17a) der von den Seitenteilen (10 bzw. 11) abstehenden Stützbolzen (16 bzw. 17) in der ersten, dem zugehörigen Seitenteil (10 bzw. 11) benachbarten Teilungsebene (14) liegen.

2. Baugruppen-Baugruppenträger-System nach Anspruch 1, dadurch gekennzeichnet, daß die Stützbolzen (4, 5) etwa im Schnittpunkt der Diagonalen der Leiterplatte (1) befestigt sind.

## Claims

1. A sub-assembly/sub-assembly carrier system for electronic circuits, in which each sub-assembly can be inserted into the sub-assembly carrier and comprises a rectangular printed circuit board, at least one side of which is furnished with electronic components, in which a respective supporting bolt is secured to a predetermined point on each side of each printed circuit board, in which the free end surface of each supporting bolt is formed as a flat contact surface and rests against the contact surface of the adjoining supporting bolt, and in which each side portion of the sub-assembly carrier has a supporting bolt which projects inwardly, is provided with a flat contact surface, is in alignment with the supporting bolts of the printed circuit boards of the sub-assemblies and the contact surface of which rests on the contact surface of the adjoining supporting bolt of a printed circuit board, characterised in that the sub-assembly carrier has a spacing dimension (T) defined by perforated strips (12 and 13), that the sub-assemblies are inserted into guide strips (15) which are fixed in apertures (12a and 13a) in the perforated strips (12 and 13), that the overall length of the two supporting bolts (4 and 5) of a printed circuit board (1), together with the thickness (d) of the printed circuit board (1) corresponds to a whole-number multiple ($n \times T$) of the spacing dimension (T) and the length ($l_1$ or $l_2$) of each supporting bolt is so selected that its contact surface (4a or 5a) is arranged in a dividing plane (14) which is determined by the spacing dimension (T) of the sub-assembly carrier, whereby the contact surfaces (16a and 17a) of the supporting bolts (16 and 17) which project from the side portions (10 and 11) are located in the first dividing plane (14) which adjoins the side portion in question (10 or 11).

2. A sub-assembly/sub-assembly carrier system as claimed in Claim 1, characterised in that the supporting bolts (4, 5) are secured approximately at the point of intersection of the diagonals of the printed circuit board (1).

**Revendications**

1. Système d'assemblages de circuits ou de supports pour assemblages de circuits pour des circuits électroniques, du type dans lequel chaque assemblage de circuits est susceptible d'être inséré dans le support pour assemblages de circuits et comporte une plaque rectangulaire de circuits imprimés dont au moins une face est garnie de composants électroniques alors qu'en un emplacement prédéterminé est fixé sur les deux surfaces latérales de chaque plaque de circuits imprimés un boulon d'appui, dans lequel la face frontale libre de chaque boulon d'appui est réalisée sous la forme d'une surface d'appui plane et porte contre la surface d'appui du boulon d'appui voisin, et dans lequel chaque partie ou élément latéral du support pour assemblages de circuits comporte un boulon d'appui saillant vers l'intérieur, pourvu d'une surface d'appui plane, aligné avec les boulons d'appui des plaques de circuits imprimés des assemblages de circuits et porte par sa surface d'appui contre la surface d'appui du boulon d'appui voisin, caractérisé par le fait que le support pour assemblages de circuits est muni d'un pas de subdivision (T) déterminé par des réglettes perforées (12, 13), que les assemblages de circuits sont insérés dans des réglettes de guidage (15) qui sont fixées dans des trous (12a, 13a) des réglettes perforées (12, 13), que la longueur totale des deux boulons d'appui (4, 5) d'une plaque de circuits imprimés (1) correspond, avec l'épaisseur (d) de la plaque de circuits imprimés (1), à un multiple entier ($n \times T$) du pas de subdivision (T) et que la longueur ($l_1$, $l_2$) de chaque boulon d'appui est choisie de telle manière que sa surface d'appui (4a, 4b) se situe dans un plan de subdivision (14) déterminé par le pas de subdivision (T) du support pour assemblages de circuits, les surfaces d'appui (16a, 17a) du boulon d'appui (16, 17) saillant sur les parties latérales se situant dans le premier plan de subdivision voisin de la partie latérale associée.

2. Système d'assemblages de circuits ou de supports pour assemblages de circuits selon la revendication 1, caractérisé par le fait que les boulons d'appui (4, 5) sont fixés à peu près au niveau de l'intersection des diagonales de la plaque de circuits imprimés (1).

FIG 1

FIG 2